Europäisches Patentamt

European Patent Office

Office européen des brevets

(19)

(11) Numéro de publication : **0 549 404 A1**

# (12) DEMANDE DE BREVET EUROPEEN

(21) Numéro de dépôt : 92403397.0

(22) Date de dépôt : 14.12.92

(51) Int. Cl.⁵ : **H04B 1/62, H03K 5/06, H03K 5/159**

(30) Priorité : 20.12.91 FR 9115897

(43) Date de publication de la demande : 30.06.93 Bulletin 93/26

(84) Etats contractants désignés : **CH DE ES GB IT LI**

(71) Demandeur : **THOMSON-CSF 51, Esplanade du Général de Gaulle F-92800 Puteaux (FR)**

(72) Inventeur : **Eumurian, Grégoire, THOMSON-CSF SCPI, BP 329 F-92402 Courbevoie Cedex (FR)**

(74) Mandataire : **Albert, Claude THOMSON-CSF SCPI B.P. 329, 50, rue J.P. Timbaud F-92402 COURBEVOIE CEDEX (FR)**

(54) Circuit d'augmentation de la dynamique pour un canal de transmission d'un signal analogique fugitif à large bande, et application à un dispositif de transmission optique de plusieurs signaux fugitifs.

(57)    Le circuit comprend, après un amplificateur (1), une voie directe (Vo1) et des voies retardées et atténuées. La deuxième voie (Vo2) comprend un atténuateur (2) d'atténuation K1 et une ligne à retard (LRe1) de durée $T_1$ égale à la durée du front de montée rapide du signal fugitif. Chaque voie suivante (Vo3) est reliée à la sortie de la voie précédente et comporte aussi un atténuateur (3) et une ligne à retard (LRe2) de durée $T_1$. Un multiplexeur (4) commandé par un circuit (5) multiplexe dans le temps les fronts de montée du signal fugitif avec des atténuations K1, K1K2 etc ...

L'invention s'applique notamment à la transmission de plusieurs signaux fugitifs à grande dynamique.

FIG.3

EP 0 549 404 A1

La présente invention se rapporte à un circuit d'augmentation de la dynamique pour un canal de transmission d'un signal analogique fugitif à large bande du type présentant un front de montée très rapide de durée $T_1$ suivi d'une évolution plus lente de durée $T_o-T_1$.

Elle se rapporte aussi à l'application d'un tel circuit à un dispositif de transmission optique de plusieurs signaux fugitifs.

L'étude de phénomènes comme la foudre, les impulsions électromagnétiques, les décharges électrostatiques etc... conduit à la mesure de signaux analogiques à large bande (plusieurs centaines de mégahertz) qui sont générés par différents aspects du même phénomène : champ électrique, champ magnétique, courant, tension etc...

Ces signaux analogiques se caractérisent par une durée très limitée dans le temps, de quelques dizaines de nanosecondes à quelques microsecondes (d'où l'appellation de signaux fugitifs) et par une quasi-simultanéité due à leur origine commune.

Du fait que ces phénomènes peuvent avoir un effet destructeur important, il est souvent nécessaire d'effectuer l'analyse des signaux à une distance suffisante du phénomène et d'assurer un isolement galvanique entre le phénomène étudié et le système d'analyse.

Un des moyens les mieux adaptés pour cela est l'utilisation de transmissions par fibre optique. Lorsqu'il s'agit de transmettre des signaux à très large bande sur de grandes distances (plusieurs kilomètres à quelques centaines de kilomètres), le seul moyen analogique pour une bonne transmission par fibre optique consiste à utiliser un laser de préférence de type DFB ("Distributed Feed Back" dans la littérature anglo-saxonne) avec un isolateur optique et une liaison optique par fibre monomode.

Ce type de liaison permet, par exemple d'assurer une bande passante d'environ 20 Hz à 2 GHz avec un rapport signal à bruit de plus de 56 dB.

Le coût d'une telle liaison étant élevé, il a été proposé par la demanderesse dans la demande de brevet français N° 91 14547 déposée le 26 novembre 1991 de multiplexer dans le temps les signaux fugitifs à transmettre en utilisant des lignes à retard à large bande à fibres optiques pour retarder par des durées croissantes les signaux fugitifs respectifs et appliquer ces signaux multiplexés à une liaison optique unique.

Cependant la plupart des signaux fugitifs rencontrés dans les phénomènes du type décharge électrostatique, impulsion électromagnétique, foudre etc... présentent une dynamique importante tout en ayant une montée rapide suivie d'une évolution plus lente.

La dynamique du signal fugitif est ainsi très souvent bien supérieure à la dynamique tolérée par le canal de transmission disponible.

Un objet de l'invention est un circuit d'augmentation de la dynamique remédiant aux inconvénients précédents et permettant de multiplier la dynamique d'un canal de transmission grâce au fait que l'on transmet le signal fugitif plusieurs fois successivement avec des atténuations croissantes.

Selon l'invention, il est donc prévu un circuit d'augmentation de la dynamique pour un canal de transmission d'un signal analogique fugitif à large bande du type présentant un front de montée très rapide de durée $T_1$ suivi d'une évolution plus lente de durée $T_o-T_1$, ledit circuit étant caractérisé en ce qu'il comprend :

- M voies de transmission dudit signal fugitif délivrant à leur sortie respectivement un signal représentant ledit signal fugitif retardé de $T_1$ et atténué de $\prod\limits_{i=1}^{m-1} K_i$ pour la voie de rang $\underline{m}$ ; et
- des moyens de multiplexage pour multiplexer dans le temps les signaux de sortie desdites M voies, de manière que les signaux des premières voies soient transmis respectivement pendant des intervalles successifs de durée $T_1$ et que le signal de la dernière voie soit transmis à la suite pendant au moins une durée $T_o$.

Selon un autre aspect de l'invention, il est prévu un dispositif de transmission optique de N signaux analogiques fugitifs sensiblement simultanés à large bande passante, du type utilisant un moyen de liaison comportant une fibre optique unique à large bande pour la transmission à distance de tous ces signaux, des moyens de conversion électro-optiques pour convertir (N-1) desdits signaux fugitifs en signaux lumineux, fibres optiques recevant respectivement lesdits signaux lumineux, (N-1) de longueurs différentes telles que les retards qu'elles apportent entre deux fibres successives diffèrent d'une valeur $T_o'$, la longueur de la fibre la plus courte étant choisie de façon que le retard qu'elle apporte soit égal à $T_o'$, et des moyens de combinaison et de conversion opto-électriques pour former par multiplexage dans le temps, à partir desdits signaux lumineux retardés et du signal fugitif non retardé, un signal électrique résultant appliqué pour transmission audit moyen de liaison, ledit dispositif étant caractérisé en ce qu'il comporte, pour chaque signal fugitif, un circuit d'augmentation de la dynamique tel que défini ci-dessus, disposé avant lesdits moyens de conversion électro-optiques pour lesdits signaux fugitifs retardés optiquement et avant lesdits moyens de combinaison et de conversion opto-électriques pour ledit signal fugitif non retardé, et en ce que ladite durée $T_o'$ est choisie égale à la valeur $(M-1) T_1+T_o$.

L'invention sera mieux comprise et d'autres caractéristiques et avantages apparaîtront à l'aide de la description ci-après et des dessins joints où :
- la figure 1 est un diagramme d'un exemple de signal fugitif ;
- la figure 2 est un diagramme illustrant le principe de l'invention ;
- la figure 3 représente le schéma d'un premier mode de réalisation de circuit selon l'invention ;
- la figure 4 est le schéma d'un deuxième mode de réalisation de circuit selon l'invention ;
- la figure 5 montre le schéma d'une partie des circuits des figures 3 et 4 ;
- la figure 6 est le schéma d'une application du circuit selon l'invention à un dispositif de transmission optique de plusieurs signaux fugitifs ; et
- la figure 7 montre le schéma d'un autre mode de réalisation du dispositif de la figure 6.

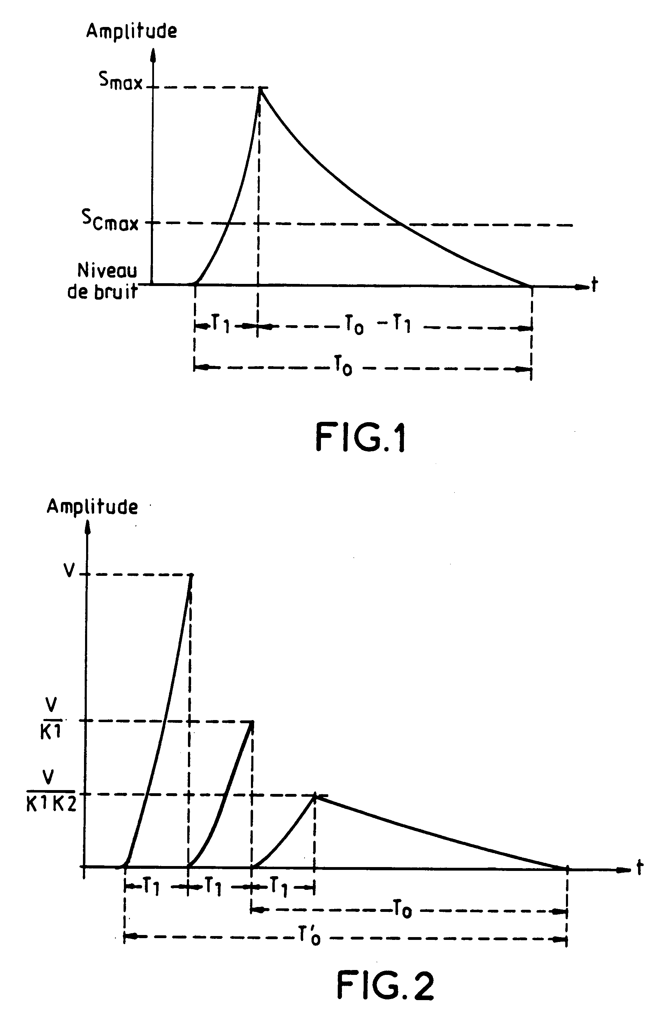

La figure 1 donne la forme typique d'un signal fugitif à large bande. Ce signal comporte un front de montée très rapide à partir du niveau de bruit jusqu'à une valeur maximum $S_{max}$ pendant une durée $T_1$ puis une évolution plus lente pendant une durée $T_o-T_1$ où $T_o$ est la durée totale du signal.

La dynamique du signal est donnée par :

$$D_{signal} = \frac{S_{max}}{\text{Bruit efficace du canal de transmission}}$$

Par ailleurs, on suppose que le canal de transmission dans lequel ce signal doit être transmis peut transmettre un signal maximum $S_{Cmax}$. La dynamique du canal de transmission est donc :

$$D_{canal} = \frac{S_{Cmax}}{\text{Bruit efficace du canal de transmission}}$$

Très souvent, $S_{Cmax}$ est inférieur à $S_{max}$.

La figure 2 illustre le principe de l'invention permettant d'apporter une solution à ce problème.

Selon l'invention, on propose de transmettre le front de montée rapide d'amplitude V pendant la durée $T_1$, puis de transmettre à nouveau ce front pendant une durée $T_1$ mais atténué d'un facteur $K_1$, puis une nouvelle fois pendant $T_1$ mais atténué d'un facteur K1.K2 et ainsi de suite (ici on n'a représenté qu'une seule retransmission avec une amplitude $\frac{V}{K1}$), enfin de transmettre une $M^{ième}$ fois le signal pendant

$$\prod_{i=1}^{M-1}$$

toute la durée $T_o$ et atténué d'un facteur $Ki$, où M est le nombre de transmissions successives. On prend à chaque fois Ki > 1. Par exemple $K_i$ peut varier de 2 à 10, sans que ces chiffres soient en rien limitatifs.

Si on appelle D la dynamique du canal de transmission, la dynamique du signal qu'on pourra effec-

$$\prod_{i=1}^{M-1}$$

tivement transmettre attreindra D. $Ki$.

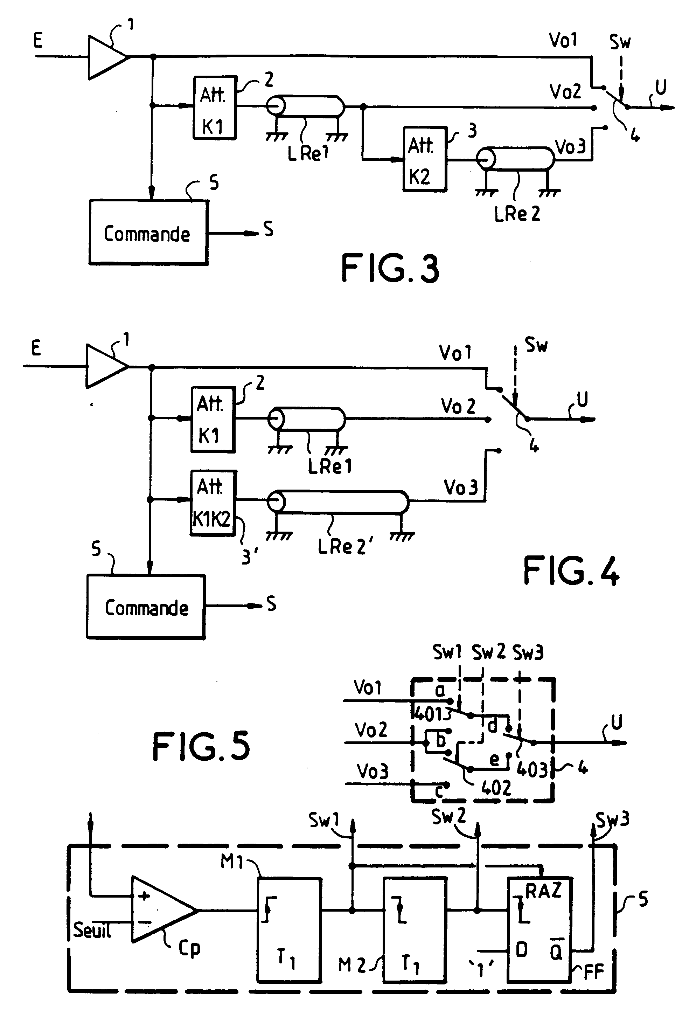

La figure 3 représente un premier exemple de circuit basé sur ce principe en supposant M = 3. Le signal fugitif est appliqué par l'entrée E sur un amplificateur 1. Celui-ci délivre le signal fugitif à une première voie Vo1 le transmettant directement. Il le délivre aussi à un atténuateur 2 d'atténuation K1 suivi en série d'une ligne à retard électrique LRe1 de durée $T_1$ qui délivre le signal d'une deuxième voie Vo2. Une telle ligne à retard peut être réalisée à l'aide d'une ligne coaxiale pour obtenir une bande passante de plusieurs centaines de mégahertz avec un retard jusqu'à plusieurs centaines de nanosecondes.

La sortie de la ligne LRe1 est reliée à un atténuateur 3 d'atténuation K2 suivi d'une ligne à retard électrique LRe2 de durée $T_1$ qui délivre le signal d'une troisième voie Vo3. On pourrait continuer de connecter d'autres voies de la même façon et on voit qu'à la sortie de chaque voie de rang m ($1 \leq m \leq M$) on retrouve le signal fugitif retardé de (m-1) $T_1$ et atténué de

$$\prod_{i=1}^{m-1} Ki.$$

Les sorties de toutes les voies Vo1 à Vo3 sont reliées aux entrées d'un commutateur 4 ayant une sortie U vers le canal de transmission (non représenté). Le commutateur 4 est commandé par un signal Sw fourni par un circuit de commande 5.

Celui-ci est prévu de telle sorte qu'il commande le commutateur 4 de la manière suivante :
- de l'instant initial d'apparition du signal fugitif choisi comme instant 0 jusqu'à $T_1$, le commutateur 4 relie la première voie Vo1 à la sortie U ;
- de $T_1$ à $2T_1$, il relie la deuxième voie Vo2 à la sortie U ;
- de $2T_1$ à $T_o'$, avec $T_o' = (M-1) T_1+T_o$, il relie la dernière voie Vo3 à la sortie U.

Naturellement, le commutateur 4 doit être un commutateur électronique rapide ayant un temps de commutation $t_{sw} \ll T_1$.

Sur la figure 4, on a représenté un autre exemple de réalisation. Les mêmes numéros de référence renvoient aux mêmes éléments dans toutes les figures. Les voies Vo1 et Vo2 sont identiques à celles de la figure 3. Par contre, les autres voies, ici Vo3, sont toutes reliées en parallèle à la sortie de l'amplificateur 1 et comportent chacune un atténuateur, ici 3' pour la

$$\prod_{i=1}^{m-1}$$

voie Vo3, d'atténuation $Ki$ et une ligne à retard, ici LRe2', de durée (m-1) $T_1$ pour la voie de rang m. Le commutateur 4 et le circuit de commande 5 sont identiques à ceux de la figure 3.

La figure 5 représente à titre d'exemple un mode de réalisation possible de ces deux éléments. On a supposé que le commutateur 4 étant formé de trois commutateurs élémentaires 401, 402, 403 formant multiplexeur commandés respectivement par les signaux de commande Sw1, Sw2, Sw3. Le circuit de commande 5 comporte d'abord un comparateur Cp recevant sur une entrée le signal fugitif venant de l'amplificateur 1 et sur son autre entrée un seuil dont la valeur est choisie très basse (par exemple (V/100). Ainsi dès l'apparition du signal fugitif, le comparateur Cp fournit une impulsion à un premier circuit monostable M1 de durée $T_1$ déclenché par le front montant de l'impulsion. Le circuit M1 fournit le signal Sw1 qui maintient le commutateur 401 dans la position a entre 0 et $T_1$ puis le laisse retomber dans la position b. Le front descendant du signal Sw1 déclenche un deuxième circuit monostable M2 de durée $T_1$ qui fournit le signal Sw2. Celui-ci maintient le commutateur 402 dans la position b entre $T_1$ et $2T_1$, le commutateur 402 étant dans la position c le reste du temps. Le front descendant du signal Sw2 met à l'état 1 une bascule FF de type D qui a été remise à zéro par le signal Sw1. La bascule FF fournit sur sa sortie $\overline{Q}$ le signal Sw3 qui maintient le commutateur 403 dans la position d de 0 à $2T_1$ puis le laisse retomber dans la position e le reste du temps.

Ainsi, entre 0 et $T_1$, la voie Vo1 est reliée à la sortie U par 401 en position a et 403 en position d. Entre $T_1$ et $2T_1$, la voie Vo2 est reliée à la sortie U par 401 en position b (402 est aussi en position b) et 403 en position d. A Par de $2T_1$, c'est la voie Vo3 qui est reliée à la sortie U par 402 en position c et 403 en position e.

Il est clair que ce mode de réalisation n'est donné qu'à titre explicatif et qu'en pratique on pourra utiliser pour le commutateur 4 un multiplexeur de type intégré bien connu à commande binaire disponible dans le commerce.

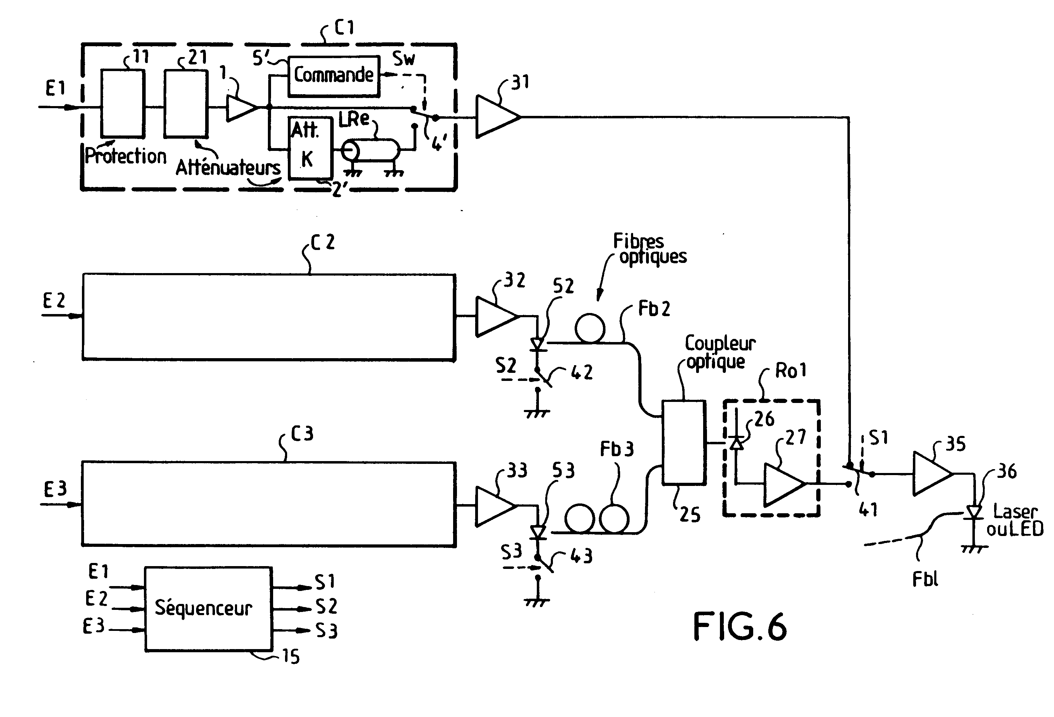

La figure 6 illustre une application particulièrement intéressante du circuit précédemment décrit à un dispositif de transmission optique de plusieurs signaux fugitifs à large bande.

Comme on l'a déjà expliqué, une liaison optique de qualité à large bande passante implique l'emploi d'une fibre optique de qualité, par exemple monomode, donc coûteuse et en général d'un laser DFB 36 également coûteux même si, dans certains cas, on peut se contenter d'une diode électroluminescente (LED) ou d'un laser FP. L'utilisation d'une liaison de ce type pour chaque signal fugitif serait d'un coût redhibitoire. La demande de brevet déjà mentionnée a proposé comme solution de multiplexer dans le temps ces signaux en les retardant de durées successives égales à $T_o$, durée d'un signal fugitif, ceci grâce à des lignes à retard optiques.

Chaque signal fugitif sur les entrées respectives E1 à E3 est appliqué à un circuit d'augmentation de dynamique selon l'invention C1 à C3. A titre d'exemple on a détaillé le circuit C1, les autres étant strictement identiques. Le circuit C1 comprend un circuit de protection 11 et un atténuateur 21 suivi de l'amplificateur 1. On a choisi un circuit à seulement deux voies pour simplifier. La deuxième voie comprend un atténuateur 2' de facteur d'atténuation K et une ligne à retard LRe de durée $T_1$. Un commutateur 4' commandé par un circuit de commande 5' multiplexe les deux voies. Les signaux de sortie des circuits C1 à C3 ont comme on l'a vu une durée $T_o'$ égale ici à $T_o+T_1$. Ils sont appliqués aux amplificateurs 31 à 33. Tous ces amplificateurs sauf le premier font partie d'émetteurs optiques utilisant des diodes électroluminescentes (LED) ou éventuellement des lasers 52, 53. Ces émetteurs transforment les signaux fugitifs correspondants en signaux lumineux injectés dans des fibres optiques Fb2, Fb3 dont les longueurs diffèrent.

Les diodes LED ou lasers 52, 53 sont connectés en série avec des interrupteurs 42, 43 commandés par des signaux S2, S3 respectivement. Les fibres optiques Fb2, Fb3 constituent des lignes à retard analogiques de très grande bande passante et de durée élevée (plusieurs centaines de mégahertz pour la bande et plusieurs microsecondes pour le retard).

Si $T_o'$ est la durée des signaux fugitifs délivrés par les circuits C2, C3 que l'on veut transmettre, on choisit de préférence la durée du retard apporté par la première fibre Fb2 égal à $T_o'$ et les autres fibres apportent des retards s'accroissant de $T_o'$ d'une fibre à la suivante. Ceci permet de multiplexer ensuite dans le temps les signaux fugitifs.

Les signaux fugitifs retardés optiquement sont combinés par un coupleur optique 25 et le signal lumineux de sortie du coupleur attaque un récepteur optique Ro1 comportant une photodiode 26 et un amplificateur 27 pour convertir ledit signal lumineux en un signal électrique intermédiaire appliqué à une borne d'un commutateur 41. Ce commutateur est commandé par un signal de commande S1 et reçoit sur sa seconde entrée le premier signal fugitif non retardé venant de l'amplificateur 31. La sortie du commutateur 41 est appliquée à l'entrée de la liaison unique de très bonne qualité, celle-ci comportant un émetteur optique comprenant l'amplificateur 35 et la diode laser DFB 36, et la fibre monomode Fb1.

Enfin, le dispositif comporte également un déclencheur-séquenceur 15 recevant les divers signaux fugitifs présents sur les entrées E1 à E3 et fournissant les signaux de commande S1 à S3.

Pendant le temps $T_o'$ à partir de l'instant initial, les signaux fugitifs des entrées E2 et E3 sont convertis en signaux lumineux puis retardés et combinés dans le coupleur 25. L'ouverture des interrupteurs tels que 42, permet d'empêcher que la suite éventuelle des signaux fugitifs correspondants ne viennent interférer dans le coupleur avec les signaux suivants. On évite ainsi tout recouvrement, tout en pouvant transmettre un dernier signal plus long si on applique un signal de fermeture permanent à l'interrupteur 43. Les signaux multiplexés dans le temps et retardés ainsi obtenus sont, après conversion par le récepteur optique Ro1, multiplexés avec le signal non retardé de la voie 1 par le commutateur 41, qui est commandé par un signal de commande S1 assurant le passage du signal de la voie 1 entre les temps 0 et $T_o$' puis le passage du signal intermédiaire issu de Ro1 pendant le reste du temps.

Grâce aux circuits C1 à C3, on peut donc transmettre par la liaison unique de qualité des signaux fugitifs de grande dynamique, supérieure à la dynamique de la liaison.

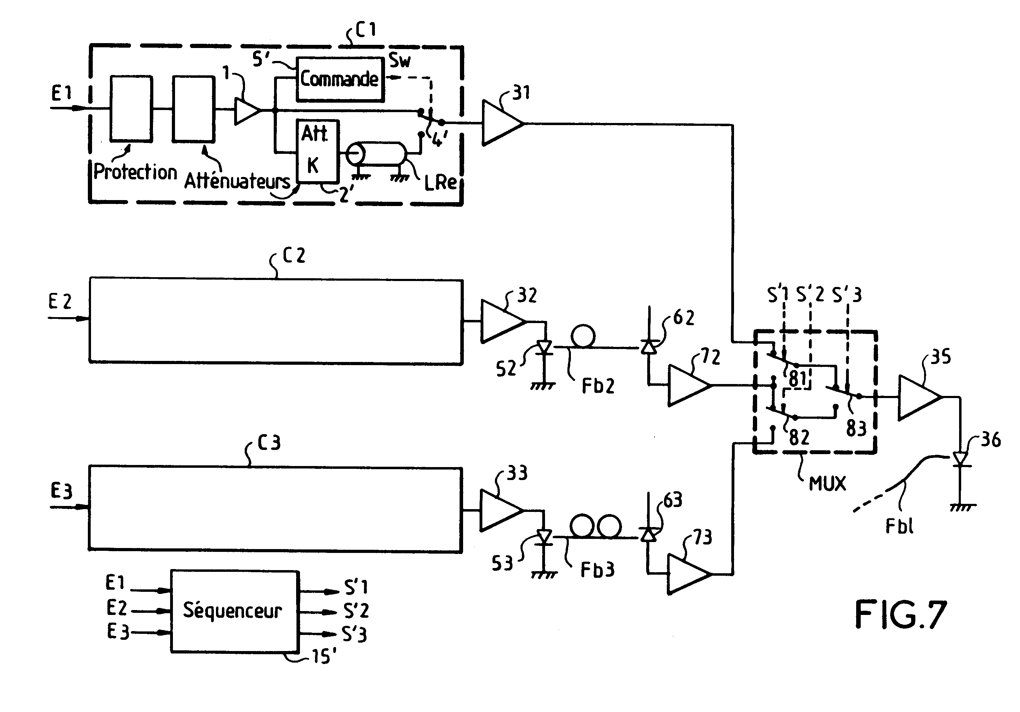

La figure 7 représente le schéma d'une autre variante de dispositif où on a remplacé le coupleur optique par plusieurs récepteurs optiques et un multiplexeur électrique.

Les émetteurs optiques 32, 33, 52, 53 ne sont plus en série avec des interrupteurs. On retrouve sur ce schéma les lignes à retard à fibre optique Fb2, Fb3. Chaque fibre optique est suivie d'un récepteur optique constitué d'une photodiode 62, 63 et d'un amplificateur 72, 73. Le premier signal électrique fugitif non retardé issu de l'amplificateur 31 et les signaux électriques retardés fournis par les récepteurs optiques 62-72 et 63-73 sont appliqués aux entrées de données d'un multiplexeur électrique MUX de tout type connu. Les entrées de commande du multiplexeur MUX reçoivent des signaux de commande S'1 à S'3. La sortie du multiplexeur fournit le signal multiplexé à l'entrée 35, 36 de la liaison optique de grande qualité. Un déclencheur-séquenceur 15' similaire au circuit 15 de la figure 6 fournit les signaux S'1 à S'3 à partir des signaux fugitifs des entrées E1 à E3.

Pour la clarté de l'explication, on a symbolisé le multiplexeur MUX par trois commutateurs 81 à 83 commandés respectivement par les signaux de commande S'1 à S'3.

A l'instant d'apparition des signaux fugitifs noté $\underline{0}$, les signaux S'1 et S'3 passent à une valeur correspondant aux positions des commutateurs 81 et 83 représentées sur la figure 7. Le premier signal fugitif et répété non retardé du circuit C1 est donc transmis vers la sortie entre les instants 0 et $T_o$'. A l'instant $T_o$', le signal S'1 retombe à une valeur correspondant à l'autre position du commutateur 81 cependant que le commutateur 83 ne change pas. Le premier signal fugitif retardé venant de l'amplificateur 72 est transmis vers la sortie entre les instants $T_o$' et $2T_o$'. A l'instant $2T_o$', le signal S'3 retombe à une valeur correspondant à l'autre position du commutateur 83 cependant que le signal S'2 passe à une valeur correspondant à la position du commutateur 82 non représentée sur la figure 7. Le second signal fugitif retardé venant de l'amplificateur 73 est donc transmis vers la sortie à partir de l'instant $2T_o$'.

Bien entendu, les exemples de réalisation décrits et leurs applications ne sont nullement limitatifs de l'invention.

**Revendications**

1. Circuit d'augmentation de la dynamique pour un canal de transmission d'un signal analogique fugitif à large bande du type présentant un front de montée très rapide de durée $T_1$ suivi d'une évolution plus lente de durée $T_o$-$T_1$, ledit circuit étant caractérisé en ce qu'il comprend :

   - M voies de transmission (Vo1, Vo2, 2, LRe1, Vo3, 3, LRe2; Vo1, Vo2, 2, LRe1, Vo3, 3', LRe2') dudit signal fugitif délivrant à leur sortie respectivement un signal représentant ledit signal fugitif retardé de (m-

$$\prod_{i=1}^{m-1}$$

1) $T_1$ et atténué de Ki pour la voie de rang $\underline{m}$ ; et

   - des moyens de multiplexage (4, 5 ; 4', 5') pour multiplexer dans le temps les signaux de sortie desdites M voies, de manière que les signaux des (M-1) premières voies soient transmis respectivement pendant des intervalles successifs de durée $T_1$ et que le signal de la dernière voie soit transmis à la suite pendant au moins une durée $T_o$.

2. Circuit selon la revendication 1, caractérisé en ce que lesdites M voies de transmission comprennent :

   - une première voie (Vo1) de transmission directe dudit signal fugitif (E) ; et
   - (M-1) voies retardées (Vo2, Vo3), avec M $\geq$ 2, comportant chacune une ligne à retard électrique (LRe1, LRe2 ; LRe1, LRe2' ; LRe) en série avec un atténuateur (2, 3 ; 2'), lesdites voies retardées ayant des lignes à retard et atténuateurs de valeurs telles et étant connectées de telle sorte que la sortie de la voie de rang $\underline{m}$ fournit un signal représentant ledit signal fugitif retardé de (m-1)

$$\prod_{i=1}^{m-1}$$

$T_1$ et atténué de Ki.

3. Circuit selon l'une des revendications 1 ou 2, caractérisé en ce que lesdits moyens de multiplexage comprennent :

   - des moyens de commutation (4 ; 4') à M entrées connectées respectivement aux sorties desdites M voies et une sortie (U) ; et
   - des moyens de commande (5 ; 5') pour commander lesdits moyens de commutation de manière à multiplexer dans le temps les signaux de sortie des M voies, les signaux des (M-1) premières voies étant transmis respectivement pendant des intervalles successifs de durée $T_1$ et le signal de la dernière voie étant transmis ensuite pendant une durée $T_o$.

4. Circuit selon l'une des revendications 2 ou 3, caractérisé en ce que chacune desdites (M-1) voies retardées (Vo2, Vo3) reçoit ledit signal fugitif et comporte en série:
- une ligne à retard (LRe1, LRe2', LRe) de durée (m-1) $T_1$ pour la voie de rang $\underline{m}$ ; et
- un atténuateur (2, 3'; 2) introduisant une atténuation $Km = \prod_{i=1}^{m-1} Ki$ pour la voie de rang m, avec $Ki > 1$.

5. Circuit selon l'une des revendications 2 ou 3, caractérisé en ce que chacune des voies de rang m est reliée à la sortie de la voie de rang m-1 et en ce que lesdites M-1 voies retardées comportent chacune en série :
- une ligne à retard (LRe1, LRe2 ; LRe) de durée $T_1$ ; et
- un atténuateur (2, 3 ; 2') introduisant une atténuation Km, où Km est supérieur à 1, pour la voie $\underline{m}$.

6. Dispositif de transmission optique de N signaux analogiques fugitifs sensiblement simultanés à large bande passante, du type utilisant un moyen de liaison (35 à 39, Fb1) comportant une fibre optique unique (Fb1) à large bande pour la transmission à distance de tous ces signaux, des moyens de conversion électro-optiques (32, 33, 52, 53) pour convertir (N-1) desdits signaux fugitifs en signaux lumineux, (N-1) fibres optiques (Fb2, Fb3) recevant respectivement lesdits signaux lumineux, de longueurs différentes telles que les retards qu'elles apportent entre deux fibres successives différent d'une valeur $T_o'$, la longueur de la fibre (Fb2) la plus courte étant choisie de façon que le retard qu'elle apporte soit égal à $T_o'$, et des moyens (25 à 27, 41, 15 ; 62, 63, 72, 73, MUX, 15') de combinaison et de conversion opto-électriques pour former par multiplexage dans le temps, à partir desdits signaux lumineux retardés et du signal fugitif non retardé, un signal électrique résultant appliqué pour transmission audit moyen de liaison (35 à 39, Fb1), ledit dispositif étant caractérisé en ce qu'il comporte, pour chaque signal fugitif, un circuit d'augmentation de la dynamique selon l'une quelconque des revendications 1 à 5 disposé avant lesdits moyens de conversion électro-optiques pour lesdits (N-1) signaux fugitifs retardés optiquement et avant lesdits moyens de combinaison et de conversion opto-électriques pour ledit signal fugitif non retardé, et en ce que ladite durée $T_o'$ est choisie égale à la valeur (M-1) $T_1 + T_o$.

FIG.1

FIG.2

FIG.3

FIG.4

FIG.5

FIG.6

FIG.7

Office européen
des brevets

**RAPPORT DE RECHERCHE EUROPEENNE**

Numero de la demande

EP    92 40 3397

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-2 912 601 (L.SLATTEN)<br>* colonne 1, ligne 31 - ligne 33 *<br>* colonne 1, ligne 56 - colonne 2, ligne 32 *<br>--- | 1,2,4 | H04B1/62<br>H03K5/06<br>H03K5/159 |
| A | IBM TECHNICAL DISCLOSURE BULLETIN.<br>vol. 5, no. 1, Juin 1962, NEW YORK US<br>page 32<br>J. ROGERS ET AL. 'DELAY LINE APPLICATIONS'<br>* le document en entier *<br>--- | 1 | |
| A | FR-A-2 450 539 (COMPAGNIE LYONNAISE DE TRANSMISSIONS OPTIQUES)<br>* page 1, ligne 18 - page 2, ligne 21, alinéa 6 *<br><br>----- | 6 | |

**DOMAINES TECHNIQUES RECHERCHES (Int. Cl.5 )**

H04B
H03K
H04J

Le présent rapport a été établi pour toutes les revendications

| Lieu de la recherche | Date d'achèvement de la recherche | Examinateur |
|---|---|---|
| LA HAYE | 11 MARS 1993 | HOLPER G.E.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)